# EUROPEAN PATENT SPECIFICATION

(11) **EP 3 439 175 B1**
(45) Date of publication and mention of the grant of the patent: **29.04.2020**
(21) Application number: 17184434.3
(22) Date of filing: 02.08.2017
(51) Int. Cl.: H03F 3/45

(54) **INPUT CURRENT ADJUSTMENT FOR FULLY DIFFERENTIAL TRANSIMPEDANCE AMPLIFIERS**
EINGANGSSTROMANPASSUNG FÜR KOMPLETT DIFFERENTIELLE TRANSIMPEDANZVERSTÄRKER
RÉGLAGE DE COURANT D'ENTRÉE POUR AMPLIFICATEURS DE TRANSIMPÉDANCE DIFFÉRENTIELLE TOTALE

(43) Date of publication of application: 06.02.2019
(73) Proprietor: IHP GmbH - Innovations for High Performance Microelectronics / Leibniz-Institut für innovative Mikroelektronik, 15236 Frankfurt (Oder) (DE)
(72) Inventor: Awny, Ahmed, 30657 Hannover (DE); Kissinger, Dietmar, 91054 Buckenhof (DE)
(74) Representative: Eisenführ Speiser

(56) References cited:
- US-A1- 2005 168 276
- US-A1- 2013 257 536
- US-A1- 2015 077 183
- US-B1- 7 592 871
- US-B2- 7 382 191
- SUNG MIN PARK ET AL: "1-Gb/s 80-dB/spl Omega/ fully differential CMOS transimpedance amplifier in multichip on oxide technology for optical interconnects", IEEE JOURNAL OF SOLID-STATE CIRCUITS., vol. 39, no. 6, 1 June 2004 (2004-06-01), pages 971-974, XP055444283, PISCATAWAY, NJ, USA ISSN: 0018-9200, DOI: 10.1109/JSSC.2004.827795
- ROGER YUBTZUAN CHEN ET AL: "A CMOS infrared optical preamplifier with a variable-gain transimpedance amplifier", CIRCUITS AND SYSTEMS, 2004. PROCEEDINGS. THE 2004 IEEE ASIA-PACIFIC CO NFERENCE ON TAINAN, TAIWAN DEC. 6-9, 2004, PISCATAWAY, NJ, USA,IEEE, vol. 1, 6 December 2004 (2004-12-06), pages 265-268, XP010783097, ISBN: 978-0-7803-8660-0

## Description

### FIELD OF THE INVENTION

The invention relates to a fully differential transimpedance amplifier, to an integrated coherent receiver comprising the fully differential transimpedance amplifier, and to a method for adjusting input currents in a fully differential transimpedance amplifier.

### BACKGROUND OF THE INVENTION

Transimpedance amplifiers are current-to-voltage converters that are often used for amplifying the output of sensors that have a current response that is more linear than the voltage response. This is, for example, the case with photodiodes, where it is not uncommon for the current response to have better than 1% linearity over a wide range of light input.

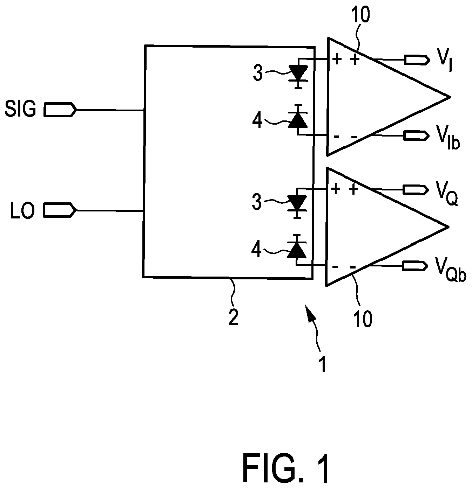

The fully differential transimpedance amplifier (in the following also referred to as "TIA") is an important building block in the integrated coherent receivers employed in long-haul fiber optic communication systems. As shown schematically and exemplarily in Fig. 1, in such an integrated coherent receiver 1 a 90° optical hybrid mixer 2 is used to mix a laser local oscillator signal LO with a modulated signal SIG. The 90° optical hybrid mixer 2 generates four signals: SIG + LO, SIG - LO, SIG + j . LO and SIG - j · LO. A first semi-balanced photodiode (PD) pair 3 and 4 is illuminated in a complementary fashion according to the signals SIG + LO and SIG - LO and a second semi-balanced photodiode (PD) pair 3 and 4 is illuminated in a complementary fashion according to the signals SIG + j · LO and SIG - j · LO. The output currents from the PDs 3 and 4 are the inputs to a respective TIA 10. The TIA 10 converts the currents to voltage signals and amplifies them to be further processed in the system.

A general problem with semi-balanced PDs is the tolerance in the manufacturing process, which leads to mismatches in the AC and DC currents provided to the differential inputs of the TIA. This may lead to DC offsets at the outputs of the TIA. Furthermore in coherent receivers, the two input currents to the TIA from the PDs contain a large DC part, which may change the bias point of the TIA and drive it in saturation.

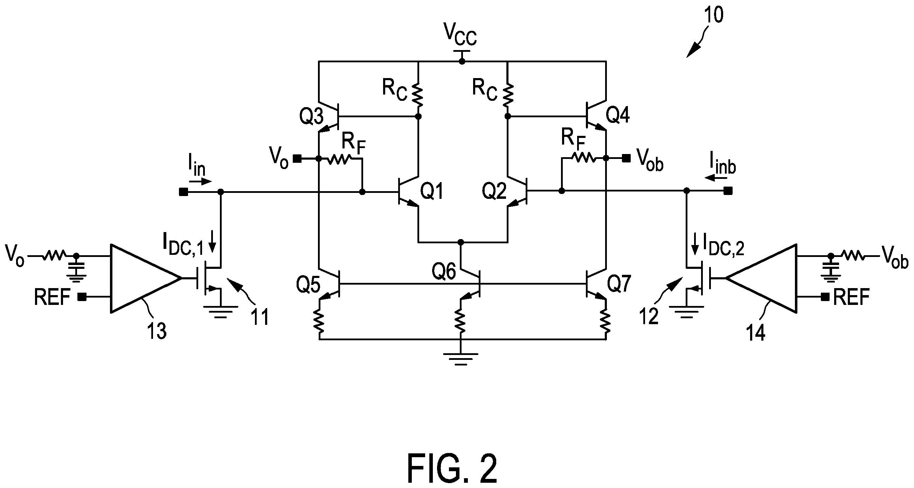

Conventionally, these problems are solved by placing two metal oxide semiconductor field effect transistors (MOSFETs, or simply MOS) 11 and 12 at the two inputs with two feedback loops, as shown schematically and exemplarity in Fig. 2. Each loop senses the DC component of the output voltages Vₒ and V_{ob} and compares it to an on-chip reference REF. Then it sets the gate of the MOS transistor 11, 12 to sink a DC current I_{DC,1}, I_{DC,2} equal to the corresponding input DC current from one of the PDs. In this manner, the DC input currents from the two PDs do not create any potential drop across the two feedback resistors R_{F} and since the reference REF is the same for both loops, the output DC offset is cancelled as well.

However, it has been found by the inventors that this conventional approach has various disadvantages: One problem is that the common mode potential of the inputs is not set correctly, since the two feedback loops work independently, which may eventually lead to instabilities when two pulses of currents are applied to the two inputs with different amplitudes. This can happen because the two loops interact with each other even though they seem to be independent, since the two inputs with different amplitudes. This can happen because the two loops interact with each other even though they seem to be independent, since the two points they sense (Vₒ and V_{ob}) and the two points they try to correct at (Iᵢₙ and I_{inb}) are the outputs and inputs of the same differential pair. Another disadvantage stems from the fact that two comparators (OpAmps) are utilized. This can lead to additional residual offset at the outputs of the TIA due to the inherent mismatch between the two comparators (OpAmps).

US 7,382,191 B2 discloses a multiplier-transimpedance amplifier combination with input common mode feedback. A current mirror is used to bias an amplifier which is connexted to a multiplier.
US 2005/168276 discloses a transimpedance amplifier comprising a feedback device coupled to an output of the amplification device and an input of the transimpedance portion to provide offset correction to the amplification device.

### SUMMARY OF THE INVENTION

It is an object of the invention to provide a fully differential transimpedance amplifier and a method for adjusting input currents of a fully differential transimpedance amplifier, which may able to avoid or at least reduce one or more of the above-mentioned disadvantages. Moreover, it is an object of the invention to provide an integrated coherent receiver comprising the fully differential transimpedance amplifier.

According to an aspect of the invention, a fully differential transimpedance amplifier is presented, comprising:
- two inputs contacts for receiving input currents;
- a differential converter for converting the input currents into output voltages;
- two output contacts for outputting the output voltages;
- a common mode adjustment loop for adjusting the common mode potential of the two input contacts; and
- a differential mode adjustment loop for adjusting the differential mode at the two input contacts to cancel a residual offset between the output voltages.

Since the common mode potential of the two input contacts is adjusted by the common mode adjustment loop, it is possible to avoid instabilities that could otherwise arise when two pulses of input currents are applied to the two input contacts with different amplitudes. Thus, a more stable operation of the fully differential transimpedance amplifier can be achieved, in which oscillations are avoided or at least reduced.

Moreover, by means of the differential mode adjustment loop a residual offset between the output voltages, i.e., any offset between the DC components of the output voltages, of the fully differential transimpedance amplifier can be cancelled. For instance, in the conventional approach for handling mismatches in the DC currents provided to the input contacts of the transimpedance amplifier described with reference to Fig. 2 above, such a residual offset may be due to the inherent mismatch between the two comparators (OpAmps) 13 and 14 utilized for comparing the DC components of the output voltages Vₒ and V_{ob} to the on-chip reference REF.

By providing a common mode adjustment loop for adjusting the common mode potential of the two input contacts and a differential mode adjustment loop for adjusting the differential mode potential of the two input contacts, the common mode potential and the differential mode potential can be adjusted independently. The underlying idea here is that the input currents can be considered as comprising two parts, namely, a common mode part and a differential mode part, which can be handled independently. This allows overcoming the limitations arising from the interaction of the two feedback loops in the conventional approach.

It is preferred that the common mode adjustment loop is adapted to extract the common mode potential of the two input contacts and to compare it to a reference corresponding to the common mode potential when the input currents have no DC component. In the case where there are no DC input currents, no DC currents will be flowing into the common mode adjustment loop, which will reduce the noise contribution coming from electrical components provided in the common mode adjustment loop.

It is further preferred that the common mode adjustment loop is further adapted to sink a sum current corresponding to a sum of the DC components of the input currents. This allows adjusting the common mode potential of the two input contacts to be equal to the reference, which has advantages with respect to saturation. For instance, taking a TIA with the structure shown in Fig. 2 as an example, the adjustment of the common mode potential may have the effect that no voltage drop, which could lead to bring the TIA or any potentially following stages (e.g., a post-amplifier) into saturation, will occur on the two feedback resistors R_{F}.

It is preferred that the common mode adjustment loop comprises a first comparator, preferably, an operational amplifier, for performing the comparison of the common mode potential of the two input contacts and the reference. Since operational amplifiers have a very high gain, this can allow achieving a high gain of the differential mode adjustment loop, which may ultimately lead to smaller errors between the common mode potential of the two input contacts and the reference.

It is further preferred that the common mode adjustment loop comprises a first field effect transistor, preferably, a MOSFET, wherein the first comparator is adapted to adjust the gate potential of the first field effect transistor to produce a drain current corresponding to the sum current. A MOSFET is preferred in this position because its DC gate current is equal to zero, which will not create any extra voltage drop that could lead to errors in the common mode adjustment loop.

In a preferred variant, the common mode adjustment loop is adapted to extract the common mode potential of the two input contacts based on a signal that is sensed at a common node in the differential converter. Such a common node in the differential converter provides an easy sense point to the common-mode potential of the two input contacts.

In another preferred variant, the common mode adjustment loop is adapted to extract the common mode potential of the two input contacts by means of two large resistors which are provided behind the two input contacts. This can provide a solution to extract the common-mode potential of the two input contacts in the case where there is no access to the internal nodes of the fully differential input transimpedance stage.

It is preferred that the differential mode adjustment loop is adapted to control a distribution of the parts of the sum current into two branches of a differential pair connected to the two input contacts. Since the two DC input currents (e.g., the input DC currents Iᵢₙ and I_{inb} from the PDs in Fig. 2) may not be equal, the differential mode adjustment loop will direct more DC current into the branch with the higher DC input current.

It is further preferred that the differential mode adjustment loop is adapted to compare the DC components of the output voltages. This, for instance, allows the differential mode adjustment loop to control the distribution of the DC current in the two branches of the differential pair in such a way that the DC offset between the two output voltages is zero. By having a zero DC offset at the two output voltages, the available AC swing is not limited on either of the two outputs. Moreover, a saturation of any potentially following stages (e.g., a post-amplifier) may be avoided.

It is preferred that the differential mode adjustment loop comprises a second comparator, preferably, an operational amplifier, for performing the comparison of the DC components of the output voltages. Since operational amplifiers have a very high gain, this can allow achieving a high gain of the differential mode adjustment loop, which may ultimately lead to smaller loop errors, i.e., a smaller residual DC offset between the output voltages.

It is further preferred that a first branch of a differential pair connected to the two input contacts comprises a second field effect transistor, preferably, a MOSFET, and the second branch of the differential pair comprises a third field effect transistor, preferably, a MOSFET, wherein the second comparator is adapted to adjust the gate potential of the second field effect transistor relative to a reference that sets the gate potential of the third field effect transistor. In this case, the differential mode adjustment loop will direct more DC current from the sum current towards the branch with the higher DC input current by adjusting the difference between the reference and the input of the second field effect transistor in the correct direction, i.e., either higher or lower than the potential of the reference.

It is preferred that the fully differential transimpedance amplifier is a multi-stage transimpedance amplifier which comprises one or more additional amplifier stages before the two output contacts. This allows the output signals from the differential converter to be further amplified to the adequate amplitudes necessary for operation of subsequent processing blocks.

According to a further aspect of the invention, an integrated coherent receiver is presented, comprising:
- two photodiodes for converting light into currents; and
- the fully differential transimpedance amplifier as defined in any of claims 1 to 12,
wherein the currents from the two photodiodes are provided as input currents on the two input contacts of the fully differential transimpedance amplifier.

According to a further aspect of the invention, a method for adjusting input currents in a fully differential transimpedance amplifier is presented, comprising:
- receiving the input currents at two input contacts;
- differentially converting the input currents into output voltages; and
- outputting the output voltages at two output contacts,
wherein a common mode adjustment loop adjusts the common mode potential of the two input contacts, and
wherein a differential mode adjustment loop adjusts the differential mode potential of the two input contacts to cancel a residual offset between the output voltages.

It shall be understood that the fully differential transimpedance amplifier of claim 1, the integrated coherent receiver of claim 13, and the method for adjusting input currents in a fully differential transimpedance amplifier of claim 14 have similar and/or identical preferred embodiments, preferably, as defined in the dependent claims.

It shall be understood that a preferred embodiment of the present invention can also be any combination of the dependent claims or above embodiments with the respective independent claim.

These and other aspects of the invention will be apparent from and elucidated with reference to the embodiments described hereinafter.

### BRIEF DESCRIPTION OF THE DRAWINGS

In the following drawings:
Fig. 1 shows schematically and exemplarily an integrated coherent receiver for employment in a long-haul fiber optic communication system,
Fig. 2 shows schematically and exemplarily a known fully differential transimpedance amplifier,
Fig. 3 shows schematically and exemplarily an embodiment of a fully differential transimpedance amplifier,
Fig. 4 shows schematically and exemplarily another embodiment of a fully differential transimpedance amplifier, and
Fig. 5 shows a flowchart exemplarily illustrating an embodiment of a method for adjusting input currents in a fully differential transimpedance amplifier.

### DETAILED DESCRIPTION OF EMBODIMENTS

In the description, like elements or units are referred by like reference numerals. Moreover, if a particular element or unit or its function has been described with reference to a particular figure, the particular element or unit or its function may not be described repeatedly with reference to another figure in which it occurs.

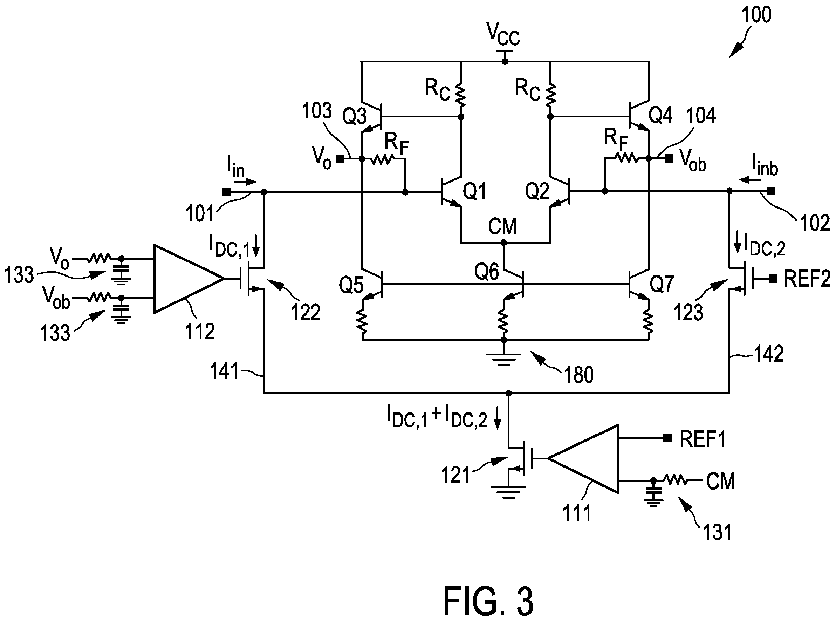

Fig. 3 shows schematically and exemplarily an embodiment of a fully differential transimpedance amplifier 100. The TIA 100 comprises two input contacts 101 and 102 for receiving input currents Iᵢₙ and I_{inb}, a differential converter 180 for converting the input currents Iᵢₙ and I_{inb} into output voltages Vₒ and V_{ob}, and two output contacts 103 and 104 for outputting the output voltages Vₒ and V_{ob}. The differential converter 180, here, is realized using a shunt-feedback topology. It comprises a plurality of bipolar transistors Q1 to Q7, resistors R_{F} and R_{C}, and a DC power supply V_{CC}. The transistors Q1 and Q2 form a differential pair that acts as the main amplifier in the circuit. The two resistors R_{F} are the feedback resistors which specify the transimpedance of the circuit. The transistors Q3 and Q4 are two emitter followers which are used as buffers to drive the post-amplifier and the two resistors R_{C} are the collector load resistors which, in addition to the magnitude of the current in the differential pair Q1 and Q2, specify the gain of the differential amplifier. The transistors Q5 to Q7 form the current sources which are used for biasing the differential pair Q1 and Q2 and the two emitter followers Q3 and Q4.

As already mentioned above, when a TIA with this structure is used in an integrated coherent receiver as described with reference to Fig. 1 above, the tolerance in the manufacturing process of the semi-balanced PDs leads to mismatches in the DC currents provided to the differential inputs of the TIA. This may lead to DC offsets at the outputs of the TIA. Furthermore in coherent receivers, the two input currents to the TIA from the PDs contain a large DC part, which may change the bias point of the TIA and drive it in saturation.

To solve these problems and to thereby also overcome the disadvantages of the above-described conventional approaches, the TIA 100 comprises, first of all, a common mode adjustment loop for adjusting the common mode potential of the input contacts 101 and 102. As can be seen from the figure, the common mode adjustment loop is adapted to extract the common mode potential of the two input contacts 101 and 102 and to compare it to a reference, here, an on-chip reference, REF1 corresponding to the common mode potential when the input currents Iᵢₙ and I_{inb} have no DC component. To this end, a first comparator 111, here, an operational amplifier (OpAmp), is provided in the common mode adjustment loop that receives the on-chip reference REF1 on a first input contact and the common mode potential of the two input contacts 101 and 102 on a second input contact and that performs the comparison of the common mode and the on-chip reference REF1.

The common mode adjustment loop is further adapted to sink a sum current corresponding to a sum of the DC components I_{DC,1} and I_{DC,2} of the input currents Iᵢₙ and I_{inb}. This is realized, in this embodiment, by providing a first field effect transistor 121, here, a MOSFET, in the common mode adjustment loop, wherein the first comparator 111 adjusts the gate potential of the first field effect transistor 121 to produce a drain current corresponding to the sum current.

In this embodiment, the common mode adjustment loop is adapted to extract the common mode potential of the input contacts 101 and 102 based on the potential that is sensed at a common node CM in the differential converter 180. A low pass filter 131, here, comprising a resistance and a capacitance, is provided to extract the DC component of the sensed signal to be input on the second input of the first comparator 111.

As mentioned above, the on-chip reference REF1 is set to correspond to the common mode potential of the two input contacts 101 and 102 when no DC input currents are injected. The potential at the common node CM then corresponds to the common mode potential of the two input contacts 101 and 102, which is set as REF1. Now, when input currents Iᵢₙ and I_{inb} having a DC component are injected into the two input contacts 101 and 102, the potential at CM changes according to the magnitude of the DC components of the current inputs as follows: The more DC input current is injected into the two input contacts 101 and 102, the lower in potential at CM goes. The first comparator 111 compares the potential at CM with the potential of REF1 and sets the gate-source potential of the first field effect transistor 121. The more DC current is injected into the two input contacts 101 and 102, the higher the difference between REF1 and CM becomes and the higher the gate-source potential is set by the first comparator 111. This leads to a drain current in MOS 121 that absorbs the two DC currents at the inputs of lin and linb. When the drain current in the first field effect transistor 121 is equal to the sum of the DC components I_{DC,1} and I_{DC,2} of the input currents Iᵢₙ and I_{inb} injected at the input contacts, the potential at the common node CM is again brought up to equal REF1.

As can be seen from Fig. 3, the two branches 141 and 142 of a differential pair are connected to the two input contacts 101 and 102 of the TIA 100 as well as to the first field effect transistor 121. The differential mode adjustment loop is adapted to control a distribution of the parts of the sum current, i.e., the parts of the current corresponding to the sum of the DC components I_{DC,1} and I_{DC,2} of the input currents Iᵢₙ and I_{inb}, into the two branches 141 and 142 of the differential pair.

In more detail, the differential mode adjustment loop is adapted to compare the DC components of the output voltages Vₒ and V_{ob}. To this end, a second comparator 112, here, an operational amplifier (OpAmp), is provided in the differential mode adjustment loop that receives the DC component of the output voltage Vₒ on a first input contact and the DC component of the output voltages V_{ob} on a second input contact and that performs the comparison of the DC components of the output voltages Vₒ and V_{ob}.

In this embodiment, the differential mode adjustment loop is adapted to extract the DC components of the output voltages Vₒ and V_{ob} based on the potentials sensed at the output contacts 103 and 104 of the TIA 100. Respective low pass filters 132 and 133, here, comprising a resistance and a capacitance, respectively, are provided to extract the DC components of the sensed potentials to be input on the first and second input contacts of the second comparator 112.

The first branch 141 of the differential pair comprises a second field effect transistor 122, here, a MOSFET, and the second branch 142 of the differential pair comprises a third field effect transistor 123, here, a MOSFET. The second comparator 112 adjusts the gate potential of the second field effect transistor 122 relative to a reference, here, an on-chip reference, REF2 that sets the gate potential of the third field effect transistor 123. The second comparator 112 adjusts the gate potential of the second field effect transistor 122 with respect to the gate potential of the third field effect transistor 123, which is equal to REF2. By adjusting the difference between the two gate potentials of the second and third field effect transistors 122 and 123, the distribution of I_{DC,1}+I_{DC,2} is set between the two branches 141 and 142 so as to cancel any offset in potential between the two output voltages Vₒ and V_{ob}. It should be noted here too, that if any mismatch exists between the two feedback resistors R_{F}, then the differential mode adjustment loop will also work to distribute I_{DC,1}+I_{DC,2} between the two branches 141 and 142 in such a way that this mismatch will not create a potential difference in DC between the two output voltages Vₒ and V_{ob}. In this respect, it is further noted that the differential mode adjustment loop may introduce an additional small offset between the currents I_{DC,1} and I_{DC,2} (not specifically indicated in the figure) by drawing different currents through the two feedback resistors R_{F}, wherein this additional small offset ultimately cancels the residual offset between the output voltages Vₒ and V_{ob}.

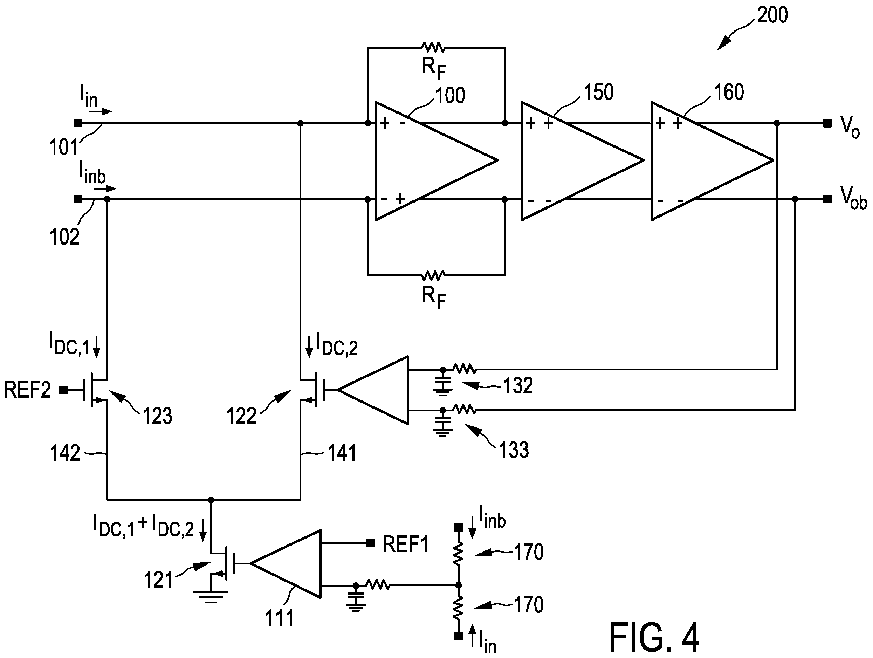

Fig. 4 shows schematically and exemplarily another embodiment of a fully differential transimpedance amplifier 200. The TIA 200 differs from the TIA 100 described with reference to Fig. 3 above in that it is a multi-stage transimpedance amplifier which comprises one or more additional amplifier stages 150, 160 before the two output contacts 103, 104. In this figure, the amplifier stage 150 may be, for instance, a conventional amplifier and the amplifier stage 160 may be a buffer amplifier, however, other combinations and/or the use of more than the illustrated two amplifier stages 150, 160 are also foreseen according to the invention.

The amplifier stages 150, 160, here, are arranged behind a stage that corresponds to the TIA 100 described with reference to Fig. 3 above. Since in this case the DC components of the output voltages Vₒ and V_{ob} are not extracted based on the potentials sensed at the output contacts of the TIA 100 but rather based on the potentials sensed at the output contacts 103 and 104 of the TIA 200, the differential mode adjustment loop, by adjusting the differential mode potential of the input contacts 101 and 102 (at the input of the TIA 100), is able to cancel a residual offset between the output voltages Vₒ and V_{ob} (at the output of the TIA 200). This is particularly advantageous, since multi-stage transimpedance amplifiers are generally prone to having high DC offsets at their outputs.

Another difference between the TIA 200 and the TIA 100 described with reference to Fig. 3 above is that in this embodiment, the common mode adjustment loop is adapted to extract the common mode of the input currents Iᵢₙ and I_{inb} by means of two large resistors 170, e.g., resistors having a value of 10 kΩ, which are provided behind the two input contacts 101, 102.

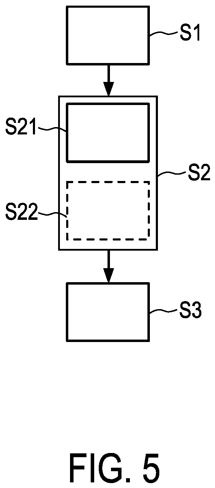

Fig. 5 shows a flowchart exemplarily illustrating an embodiment of a method for adjusting input currents in a fully differential transimpedance amplifier, for example, the TIA 100 described with reference to Fig. 3 above or the TIA 200 described with reference to Fig. 4 above.

In step S1, the input currents Iᵢₙ and I_{inb} are received on the two input contacts 101 and 102.

In step S2, the input currents Iᵢₙ and I_{inb} are differentially converted into output voltages Vₒ and V_{ob}.

In step S3, the output voltages Vₒ and V_{ob} are outputted on the two output contacts 103 and 104.

The step S2 comprises two (sub-)steps S21 and S22 that are performed as part of step S2. In (sub-)step S21, a common mode adjustment loop adjusts the common mode potential of the two input contacts 101 and 102. Moreover, in optional (sub-)step S22, a differential mode adjustment loop adjusts the differential mode potential of the two input contacts 101 and 102 to cancel a residual offset between the output voltages Vₒ and V_{ob}.

The common mode adjustment loop and/or the differential mode adjustment loop are preferentially realized as explained with reference to Figs. 3 and 4 above.

The TIA 100 described with reference to Fig. 3 above or the TIA 200 described with reference to Fig. 4 above can preferably be employed as the TIA 10 in the integrated coherent receiver 1 described with reference to Fig. 1 above.

The combination of the common mode adjustment loop and the differential mode adjustment loop, as described above, has the advantage that the DC components I_{DC,1} and I_{DC,2} of the input currents Iᵢₙ and I_{inb} from the semi-balanced PDs 3 and 4 are cancelled (compensated for) before they enter the differential converter 180 of the TIA 100 or 200 and cause a voltage drop across the two feedback resistors R_{F}, which would change the operating point of the TIA 100 or 200 and could cause it to saturate. Since the common mode adjustment loop adjusts the common mode potential of the input contacts 101 and 102, the approach is not sensitive to instability, which has been found by the inventors to be a problem with the conventional approach described with reference to Fig. 2 above. Moreover, the DC offset between the output voltages Vₒ and V_{ob} can be canceled by the differential mode adjustment loop.

While in the embodiments of the fully differential transimpedance amplifier described with reference to Figs. 3 and 4 above, the TIAs 100 and 200 are formed using bipolar transistors Q1 to Q7, the invention is not restricted to this. For instance, in other embodiments the fully differential transimpedance amplifier may be formed using MOSFETs.

While in the TIA 100, the common mode adjustment loop is adapted to extract the common mode potential of the input contacts 101 and 102 based on the potential that is sensed at a common node CM in the differential converter 180, and in the TIA 200, the common mode adjustment loop is adapted to extract the common mode of the input contacts 101 and 102 by means of two large resistors 170, e.g., resistors having a value of 10 kΩ, which are provided behind the two input contacts 101 and 102, the invention is not restricted to this. For instance, in other embodiments, the common mode adjustment loop of the TIA 100 may be adapted to extract the common mode of the input contacts 101 and 102 by means of two large resistors, which are provided behind the two input contacts 101, 102, and the common mode adjustment loop of the TIA 200 may be adapted to extract the common mode potential of the input contacts 101 and 102 based on the potential that is sensed at a common node CM in the differential converter.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality.

A single unit or device may fulfill the functions of several items recited in the claims. The mere fact that certain measures are recited in mutually different dependent claims does not indicate that a combination of these measures cannot be used to advantage.

Any reference signs in the claims should not be construed as limiting the scope. The invention relates to a fully differential transimpedance amplifier 100 or 200, comprising: two input contacts 101 and 102 for receiving input currents Iᵢₙ and I_{inb}; a differential converter 180 for converting the input currents Iᵢₙ and I_{inb} into output voltages Vₒ and V_{ob}; two output contacts 103 and 104 for outputting the output voltages Vₒ and V_{ob}; and a common mode adjustment loop for adjusting the common mode potential of the two input contacts 101 and 102 and a differential mode adjustment loop for adjusting the differential mode potential of the two input contacts (101, 102) to cancel a residual offset between the output voltages (Vo , Vob).

## Claims

1. A fully differential transimpedance amplifier (100; 200), comprising:
- two input contacts (101, 102) for receiving input currents (Iᵢₙ, I_{inb});
- a differential converter (180) for converting the input currents (Iᵢₙ, I_{inb}) into output voltages (Vₒ, V_{ob});
- two output contacts (103, 104) for outputting the output voltages (Vₒ, V_{ob});
- a common mode adjustment loop for adjusting the common mode potential of the two input contacts (101, 102); and
- a differential mode adjustment loop for adjusting the differential mode potential of the two input contacts (101, 102) to cancel a residual offset between the output voltages (Vₒ, V_{ob}).

2. The fully differential transimpedance amplifier (100; 200) as defined in claim 1, wherein the common mode adjustment loop is adapted to extract the common mode potential of the two input contacts (101, 102) and to compare it to a reference (REF1) corresponding to the common mode when the input currents (Iᵢₙ, I_{inb}) have no DC component.

3. The fully differential transimpedance amplifier (100; 200) as defined in claim 2, wherein the common mode adjustment loop is further adapted to sink a sum current corresponding to a sum of the DC components (I_{DC,1}, I_{DC,2}) of the input currents (Iᵢₙ, I_{inb}).

4. The fully differential transimpedance amplifier (100; 200) as defined in claim 2 or 3, wherein the common mode adjustment loop comprises a first comparator (111), preferably, an operational amplifier, for performing the comparison of the common mode potential of the two input contacts (101, 102) and the reference (REF1).

5. The fully differential transimpedance amplifier (100) as defined in claim 4 when referring back to claim 3, wherein the common mode adjustment loop comprises a first field effect transistor (121), preferably, a MOSFET, wherein the first comparator (111) is adapted to adjust the gate potential of the first field effect transistor (121) to produce a drain current corresponding to the sum current.

6. The fully differential transimpedance amplifier (100) as defined in any of claims 1 to 5, wherein the common mode adjustment loop is adapted to extract the common mode potential of the two input contacts (101, 102) based on the potential that is sensed at a common point (CM) in the differential converter (180).

7. The fully differential transimpedance amplifier (200) as defined in any of claims 1 to 5, wherein the common mode adjustment loop is adapted to extract the common mode potential of the two input contacts (101, 102) by means of two large resistors (170) which are provided behind the two input contacts (101, 102).

8. The fully differential transimpedance amplifier (100; 200) as defined in any of claims 3 to 7, wherein the differential mode adjustment loop is adapted to control a distribution of the parts of the sum current into two branches (141, 142) of a differential pair connected to the two input contacts (101, 102).

9. The fully differential transimpedance amplifier (100; 200) as defined in any of claims 3 to 8, wherein the differential mode adjustment loop is adapted to compare the DC components of the output voltages (Vₒ, V_{ob}).

10. The fully differential transimpedance amplifier (100; 200) as defined in claim 9, wherein the differential mode adjustment loop comprises a second comparator (121), preferably, an operational amplifier, for performing the comparison of the DC components of the output voltages (Vₒ, V_{ob}).

11. The fully differential transimpedance amplifier (100; 200) as defined in claim 10, wherein a first branch (141) of a differential pair connected to the two input contacts (101, 102) comprises a second field effect transistor (122), preferably, a MOSFET, and the second branch (142) of the differential pair comprises a third field effect transistor (123), preferably, a MOSFET, wherein the second comparator (112) is adapted to adjust the gate potential of the second field effect transistor (122) relative to a reference (REF2) that sets the gate potential of the third field effect transistor (123).

12. The fully differential transimpedance amplifier (200) as defined in any of claims 1 to 11, wherein the fully differential transimpedance amplifier (200) is a multi-state transimpedance amplifier which comprises one or more additional amplifier stages (150, 160) before the two output contacts (103, 104).

13. An integrated coherent receiver (1), comprising:
- two photodiodes (3, 4) for converting light into currents; and
- the fully differential transimpedance amplifier (100; 200) as defined in any of claims 1 to 12,
wherein the currents from the two photodiodes (3, 4) are provided as input currents (Iᵢₙ, I_{inb}) on the two input contacts (101, 102) of the fully differential transimpedance amplifier (100; 200).

14. A method for adjusting input currents (Iᵢₙ, I_{inb}) in a fully differential transimpedance amplifier (100; 200), comprising:
- receiving (S1) the input currents (Iᵢₙ, I_{inb}) on two input contacts (101, 102);
- differentially converting (S2) the input currents (Iᵢₙ, I_{inb}) into output voltages (Vₒ, V_{ob}); and
- outputting (S3) the output voltages (Vₒ, V_{ob}) on two output contacts (103, 104),
wherein a common mode adjustment loop adjusts (S21) the common mode potential of the two input contacts (101, 102), and
wherein a differential mode adjustment loop adjusts (S22) the differential mode potential of the two input contacts (101, 102) to cancel a residual offset between the output voltages (Vₒ, V_{ob}).

## Patentansprüche

1. Voll-differentialer Transimpedanzverstärker (100; 200), umfassend:
- zwei Eingangskontakte (101,102) zum Empfangen von Eingangsströmen (Iᵢₙ, I_{inb});
- einen Differenzialwandler (180) zum Umwandeln der Eingangsströme (Iᵢₙ, I_{inb}) in Ausgangsspannungen (Vₒ, V_{ob});
- zwei Ausgangskontakte (103,104) zum Ausgeben der Ausgangsspannungen (Vₒ, V_{ob});
- eine Gleichtakt-Einstellschleife zum Einstellen des Gleichtaktpotentials der zwei Eingangskontakte (101, 102); und
- eine Differentialmodus-Einstellschleife zum Einstellen des Differentialmodus-Potentials der zwei Eingangskontakte (101, 102), um einen Restversatz zwischen den Ausgangsspannungen (Vₒ, V_{ob}) aufzuheben.

2. Voll-differentialer Transimpedanzverstärker (100; 200) nach Anspruch 1, wobei die Gleichtakt-Einstellschleife angepasst ist, das Gleichtaktpotential der zwei Eingangskontakte (101, 102) zu extrahieren und es mit einer Referenz (REF1), die dem Gleichtakt entspricht, wenn die Eingangsströme (Iᵢₙ, I_{inb}) keine Gleichstromkomponente aufweisen, zu vergleichen.

3. Voll-differentialer Transimpedanzverstärker (100; 200) nach Anspruch 2, wobei die Gleichtakt-Einstellschleife des Weiteren angepasst ist, einen Summenstrom, der einer Summe der Gleichstromkomponenten (I_{DC,1}, I_{DC,2}) der Eingangsströme (Iᵢₙ, I_{inb}) entspricht, aufzunehmen.

4. Voll-differentialer Transimpedanzverstärker (100; 200) nach Anspruch 2 oder 3, wobei die Gleichtakt-Einstellschleife einen ersten Komparator (111), vorzugsweise einen Operationsverstärker, zum Durchführen des Vergleichs des Gleichtaktpotentials der zwei Eingangskontakte (101, 102) und der Referenz (REF1), umfasst.

5. Voll-differentialer Transimpedanzverstärker (100; 200) nach Anspruch 4, wenn dieser auf Anspruch 3 zurückbezogen ist, wobei die Gleichtakt-Einstellschleife einen ersten Feldeffekttransistor (121), vorzugsweise einen MOSFET, umfasst, wobei der erste Komparator (111) angepasst ist, das Gate-Potential des ersten Feldeffekttransistors (121) einzustellen, um einen Drain-Strom zu erzeugen, der dem Summenstrom entspricht.

6. Voll-differentialer Transimpedanzverstärker (100; 200) nach einem der Ansprüche 1 bis 5, wobei die Gleichtakt-Einstellschleife angepasst ist, das Gleichtakt-Potential der zwei Eingangskontakte (101, 102) auf der Grundlage des Potentials, das an einem gemeinsamen Punkt (CM) in dem Differenzialwandler (180) erfasst wird, zu extrahieren.

7. Voll-differentialer Transimpedanzverstärker (100; 200) nach einem der Ansprüche 1 bis 5, wobei die Gleichtakt-Einstellschleife angepasst ist, das Gleichtakt-Potential der zwei Eingangskontakte (101, 102) mittels zweier großer Widerstände (170), die hinter den zwei Eingangskontakten (101, 102) bereitgestellt sind, zu extrahieren.

8. Voll-differentialer Transimpedanzverstärker (100; 200) nach einem der Ansprüche 3 bis 7, wobei die Differentialmodus-Einstellschleife angepasst ist, eine Verteilung der Teile des Summenstroms auf zwei Zweige (141, 142) eines mit den zwei Eingangskontakten (101, 102) verbundenen Differentialpaares zu steuern.

9. Voll-differentialer Transimpedanzverstärker (100; 200) nach einem der Ansprüche 3 bis 8, wobei die Differentialmodus-Einstellschleife angepasst ist, die Gleichstromkomponenten der Ausgangsspannungen (Vₒ, V_{ob}) zu vergleichen.

10. Voll-differentialer Transimpedanzverstärker (100; 200) nach Anspruch 9, wobei die Differentialmodus-Einstellschleife einen zweiten Komparator (121), vorzugsweise einen Operationsverstärker, zum Durchführen des Vergleichs der Gleichstromkomponenten der Ausgangsspannungen (Vₒ, V_{ob}) umfasst.

11. Voll-differentialer Transimpedanzverstärker (100; 200) nach Anspruch 10, wobei ein erster Zweig (141) eines Differentialpaares, das mit den zwei Eingangskontakten (101, 102) verbunden ist, einen zweiten Feldeffekttransistor (122), vorzugsweise einen MOSFET, umfasst und der zweite Zweig (142) des Differentialpaares einen dritten Feldeffekttransistor (123), vorzugsweise einen MOSFET, umfasst, wobei der zweite Komparator (112) angepasst ist, das Gatepotential des zweiten Feldeffekttransistors (122) relativ zu einer Referenz (REF2), die das Gatepotential des dritten Feldeffekttransistors (123) einstellt, einzustellen.

12. Voll-differentialer Transimpedanzverstärker (200) nach einem der Ansprüche 1 bis 11, wobei der voll-differentiale Transimpedanzverstärker (200) ein Mehrstufen-Transimpedanzverstärker ist, der eine oder mehrere zusätzliche Verstärkerstufen (150, 160) vor den zwei Ausgangskontakten (103, 104) aufweist.

13. Integrierter kohärenter Empfänger (1), umfassend:
- zwei Fotodioden (3, 4) zum Umwandeln von Licht in Ströme; und
- den voll-differentialen Transimpedanzverstärker (100; 200) nach einem der Ansprüche 1 bis 12,
wobei die Ströme von den zwei Fotodioden (3, 4) als Eingangsströme (Iᵢₙ, I_{inb}) an den zwei Eingangskontakten (101, 102) des voll-differentialen Transimpedanzverstärkers (100; 200) bereitgestellt werden.

14. Verfahren zum Einstellen von Eingangsströmen (Iᵢₙ, I_{inb}) in einem voll-differentialen Transimpedanzverstärker (100; 200), umfassend:
- Empfangen (S1) der Eingangsströme (Iᵢₙ, I_{inb}) an zwei Eingangskontakten (101, 102);
- differentiales Umwandeln (S2) der Eingangsströme (Iᵢₙ, I_{inb}) in Ausgangsspannungen (Vₒ, V_{ob}); und
- Ausgeben (S3) der Ausgangsspannungen (Vₒ, V_{ob}) an zwei Ausgangskontakten (103, 104),
wobei eine Gleichtakt-Einstellschleife das Gleichtakt-Potential der zwei Eingangskontakte (101, 102) einstellt (S21), und
wobei eine Differenzialmodus-Einstellschleife das Differentialmodus-Potential der zwei Eingangskontakte (101, 102) einstellt (S22), um einen Restversatz zwischen den Ausgangsspannungen (Vₒ, V_{ob}) aufzuheben.

## Revendications

1. Amplificateur à transimpédance entièrement différentiel (100 ; 200), comprenant :
- deux contacts d'entrée (101, 102) pour recevoir des courants d'entrée (Iᵢₙ, I_{inb});
- un convertisseur différentiel (180) pour convertir les courants d'entrée (Iᵢₙ, I_{inb}) en tensions de sortie (Vₒ, V_{ob}) ;
- deux contacts de sortie (103, 104) pour délivrer les tensions de sortie (Vₒ, V_{ob}) ;
- une boucle de réglage de mode commun pour régler le potentiel de mode commun des deux contacts d'entrée (101, 102) ; et
- une boucle de réglage de mode différentiel pour régler le potentiel de mode différentiel des deux contacts d'entrée (101, 102) pour annuler un décalage résiduel entre les tensions de sortie (Vₒ, V_{ob}).

2. Amplificateur à transimpédance entièrement différentiel (100 ; 200) selon la revendication 1, dans lequel la boucle de réglage de mode commun est adaptée pour extraire le potentiel de mode commun des deux contacts d'entrée (101, 102) et pour le comparer à une référence (REF1) correspondant au mode commun lorsque les courants d'entrée (Iᵢₙ, I_{inb}) n'ont pas de composante CC.

3. Amplificateur à transimpédance entièrement différentiel (100 ; 200) selon la revendication 2, dans lequel la boucle de réglage de mode commun est en outre adaptée pour absorber un courant de somme correspondant à une somme des composantes CC (I_{DC.1}, I_{DC.2}) des courants d'entrée (Iᵢₙ, I_{inb}).

4. Amplificateur à transimpédance entièrement différentiel (100 ; 200) selon la revendication 2 ou 3, dans lequel la boucle de réglage de mode commun comprend un premier comparateur (111), de préférence un amplificateur opérationnel, pour effectuer la comparaison du potentiel de mode commun de les deux contacts d'entrée (101, 102) et la référence (REF1).

5. Amplificateur à transimpédance entièrement différentiel (100) selon la revendication 4, en se référant à la revendication 3, dans lequel la boucle de réglage de mode commun comprend un premier transistor à effet de champ (121), de préférence un MOSFET, dans lequel le premier comparateur (111) est adapté pour ajuster le potentiel de grille du premier transistor à effet de champ (121) pour produire un courant de drain correspondant au courant de somme.

6. Amplificateur à transimpédance entièrement différentiel (100) selon l'une quelconque des revendications 1 à 5, dans lequel la boucle de réglage de mode commun est adaptée pour extraire le potentiel de mode commun des deux contacts d'entrée (101, 102) sur la base du potentiel qui est détecté en un point commun (CM) dans le convertisseur différentiel (180).

7. Amplificateur à transimpédance entièrement différentiel (200) selon l'une quelconque des revendications 1 à 5, dans lequel la boucle de réglage de mode commun est adaptée pour extraire le potentiel de mode commun des deux contacts d'entrée (101, 102) au moyen de deux grandes résistances (170) qui sont prévues après les deux contacts d'entrée (101, 102).

8. Amplificateur à transimpédance entièrement différentiel (100 ; 200) tel que défini dans l'une quelconque des revendications 3 à 7, dans lequel la boucle de réglage de mode différentiel est adaptée pour contrôler une distribution des parties du courant de somme en deux branches (141, 142) d'une paire différentielle connectée aux deux contacts d'entrée (101, 102).

9. Amplificateur à transimpédance entièrement différentiel (100 ; 200) selon l'une quelconque des revendications 3 à 8, dans lequel la boucle de réglage de mode différentiel est adaptée pour comparer les composantes CC des tensions de sortie (Vₒ, V_{ob}).

10. Amplificateur à transimpédance entièrement différentiel (100 ; 200) selon la revendication 9, dans lequel la boucle de réglage de mode différentiel comprend un deuxième comparateur (121), de préférence un amplificateur opérationnel, pour effectuer la comparaison des composantes CC des tensions de sortie (Vₒ, V_{ob}).

11. Amplificateur à transimpédance entièrement différentiel (100 ; 200) selon la revendication 10, dans lequel une première branche (141) d'une paire différentielle connectée aux deux contacts d'entrée (101, 102) comprend un deuxième transistor à effet de champ (122), de préférence un MOSFET, et la deuxième branche (142) de la paire différentielle comprend un troisième transistor à effet de champ (123), de préférence un MOSFET, dans lequel le deuxième comparateur (112) est adapté pour ajuster le potentiel de grille du deuxième transistor à effet de champ (122) par rapport à une référence (REF2) qui définit le potentiel de grille du troisième transistor à effet de champ (123).

12. Amplificateur à transimpédance entièrement différentiel (200) tel que défini dans l'une quelconque des revendications 1 à 11, dans lequel l'amplificateur à transimpédance entièrement différentiel (200) est un amplificateur à transimpédance à états multiples qui comprend un ou plusieurs étages amplificateurs supplémentaires (150, 160) avant les deux contacts de sortie (103, 104).

13. Récepteur cohérent intégré (1), comprenant :
- deux photodiodes (3, 4) pour convertir la lumière en courants ; et
- l'amplificateur à transimpédance entièrement différentiel (100 ; 200) selon l'une quelconque des revendications 1 à 12,
dans lequel les courants provenant des deux photodiodes (3, 4) sont fournis sous forme de courants d'entrée (Iᵢₙ, I_{inb}) sur les deux contacts d'entrée (101 , 102) de l'amplificateur à transimpédance entièrement différentiel (100 ; 200).

14. Procédé pour régler les courants d'entrée (Iᵢₙ, I_{inb}) dans un amplificateur à transimpédance entièrement différentiel (100 ; 200), comprenant :
la réception (S1) des courants d'entrée (Iᵢₙ, I_{inb}) sur deux contacts d'entrée (101, 102);
la conversion différentielle (S2) des courants d'entrée (Iᵢₙ, I_{inb}) en tensions de sortie (Vₒ, V_{ob}) ; et
la fourniture en sortie (S3) des tensions de sortie (Vₒ, V_{ob}) sur deux contacts de sortie (103, 104),
dans lequel une boucle de réglage de mode commun ajuste (S21) le potentiel de mode commun des deux contacts d'entrée (101, 102), et
dans lequel une boucle de réglage de mode différentiel ajuste (S22) le potentiel de mode différentiel des deux contacts d'entrée (101, 102) pour annuler un décalage résiduel entre les tensions de sortie (Vₒ, V_{ob}).
